# EUROPEAN PATENT APPLICATION

(11) **EP 4 772 680 A1**
(43) Date of publication of application: **08.07.2026**
(21) Application number: 24859189.3
(22) Date of filing: 12.07.2024
(51) Int. Cl.: C30B 29/06, C30B 15/00, C30B 33/02, H01L 21/26

(54) **SINGLE-CRYSTAL SILICON SUBSTRATE AND METHOD FOR PRODUCING SINGLE-CRYSTAL SILICON SUBSTRATE**

(30) Priority: 28.08.2023 JP 2023138104
(71) Applicant: Shin-Etsu Handotai Co., Ltd., Tokyo 100-0004 (JP)
(72) Inventor: ISHIBIKI, Ryota, Nishishirakawa-gun, Fukushima 961-8061 (JP); OHTSUKI, Tsuyoshi, Nishishirakawa-gun, Fukushima 961-8061 (JP)
(74) Representative: Schicker, Silvia
(86) International application number: PCT/JP2024/025212
(87) International publication number: WO 2025/047145

(57) **Abstract**

The present invention is directed to a silicon single-crystal substrate having a plane orientation of (110), in which a surface of the silicon single-crystal substrate in a room temperature environment has a surface stable structure 1×1. This provides a silicon single-crystal substrate that has reduced haze of the silicon (110) substrate and thus has a stable surface structure, and a method for manufacturing the silicon single-crystal substrate.

## Description

### TECHNICAL FIELD

The present invention relates to a silicon single-crystal substrate and a method for manufacturing the silicon single-crystal substrate.

### BACKGROUND ART

In place of the Fin structure, adopted in the present logic ICs, proposed in the next generation or further are gate all around (GAA) and complementary field effect transistor (CFET) in which NMOS and CMOS are stacked, and these have been actively researched and developed. In these cases, it is considered to utilize a silicon (hereinafter, also described as Si) substrate having a plane orientation of (110) as a technique to improve hole mobility (Non Patent Document 1).

However, it has been pointed out that the silicon (110) substrate has a problem of large surface roughness and haze (Non Patent Document 1). Here, the haze is also called a degree of cloudiness on the surface, which is surface roughness expressed as a degree of light scattering, and a larger haze means a rougher surface. Additionally, the most stable structure of the silicon (110) outermost surface has been relatively recently confirmed (Non Patent Documents 2 and 3).

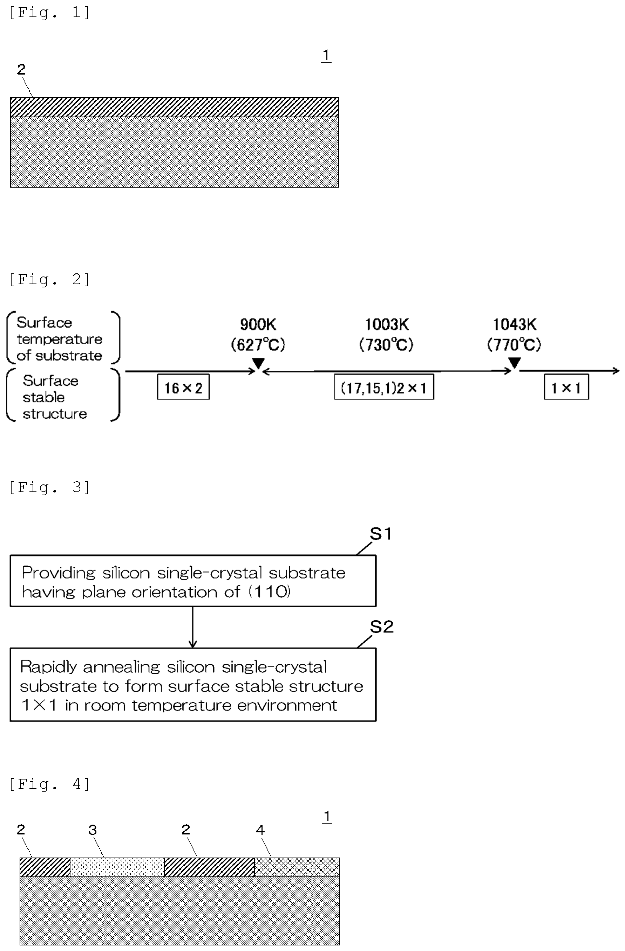

In addition, according to the description in Non Patent Documents 2 and 3, a 16×2 domain, which is the most stable surface stable structure, undergoes phase transition due to temperature, and the structure changes within a range of 900 K (627°C) to 1043 K (770°C) as shown in FIG. 2 (hereinafter, referred to as the range of 600 to 800°C). This temperature band forms once a surface stable structure 1×1 stable at high temperature because hydrogen baking to grow, for example, a silicon epitaxial layer (hereinafter, also simply referred to as epi or epitaxial) or the subsequent silicon epi are performed at more than 1000°C, but the phase transition occurs in subsequent cooling with slowly passing the temperature through the range of 600 to 800°C, and the surface structure changes also depending on the passing time. For example, materials such as SiGe, which are stacked in GAA or CFET, usually use just this temperature band, which make it more difficult to understand the surface structure.

This surface structure unique to the silicon (110) plane also affects a surface structure after etching. A step edge of the 16×2 surface structure has not a single-atom structure like silicon (100) but a step equivalent to two atoms. This step allows the reaction to proceed at the outermost atom when the reaction system has small energy (an equilibrium reaction), and the surface geometry after etching has consequently a linear structure surrounded by the first subsurface silicon (111). Meanwhile, when the reaction system has large energy, atoms at the outermost surface and atoms therebelow are involved in the reaction, and quadrangular geometry surrounded by the second subsurface silicon (111) consequently appears.

For silicon (110) having such a plane state, Patent Document 1 discloses a technique of reducing surface roughness by tilting orientation during epi-growth. Patent Document 2 discloses determination of a cooling rate and surface protection. Further, Patent Document 3 discloses determination of the plane orientation during not the epi but crystal growth to similarly reduce the surface roughness. Patent Document 4 discloses polishing of the epi surface. Moreover, Patent Document 5 discloses combination of Patent Documents 1 and 3.

### CITATION LIST

### NON PATENT LITERATURE

Non Patent Document 1: The Japan Society of Applied Physics, Industry-academia collaboration committee on semiconductor crystal growth, processing and characterization, the first workshop, "Crystal Technology to Support Restoration of Semiconductor".
Non Patent Document 2: Yamada, et. al., "Fabrication of Si(110)-16×2 Single-domain Surface", JOURNAL OF THE SURFACE SCIENCE SOCIETY OF JAPAN, 29 (7), 401 (2008).
Non Patent Document 3: Miyachi, et. al., "Ultrahigh Vacuum Non-Contact Atomic Force Microscope Observation of Reconstructed Si(110) Surface", J. Japan Inst. Met. Mater., 72 (4), 290 (2008).

### PATENT LITERATURE

| | |
|---|---|
| Patent Document 1: | JP 2008-091887 A |
| Patent Document 2: | JP 2006-100596 A |
| Patent Document 3: | JP 2008-088045 A |
| Patent Document 4: | JP 2014-239184 A |
| Patent Document 5: | JP 2008-091891 A |

### SUMMARY OF INVENTION

### TECHNICAL PROBLEM

As noted above, the surface of the silicon (110) substrate has extremely complex geometry, and various techniques for relaxing the surface roughness have been disclosed. However, the silicon (110) substrate specifically has a special structure 16×2 (a structure having a step equivalent to two atoms) as the most stable surface stable structure, which differs from the silicon (100) substrate. In addition, the structure transition temperature is 600 to 800°C, and there has been a problem of inevitable haze due to change in the surface structure in a step of passing through this temperature band in heating or cooling specifically as the epi-growth.

The present invention has been made in view of the problem of the above conventional art, and an object of the present invention is to provide a silicon single-crystal substrate that has reduced haze of the silicon (110) substrate and thus has a stable surface structure, and a method for manufacturing the silicon single-crystal substrate.

### SOLUTION TO PROBLEM

To solve the above problem, the silicon single-crystal substrate of the present invention has a plane orientation of (110), and a surface of the silicon single-crystal substrate in a room temperature environment has a surface stable structure 1×1.

The silicon (110) substrate having the surface stable structure 1×1 in a room temperature environment as above, first, has reduced haze because of the surface stable structure 1×1, which differs from the structure having a step equivalent to two atoms like the surface stable structure 16×2. Second, the room temperature environment, which distanced from the structure transition temperature of the silicon (110) substrate (600 to 800°C), hardly changes the structure, which yields the stable surface structure.

In addition, a method for manufacturing a silicon single-crystal substrate of the present invention is a method comprising: providing a silicon single-crystal substrate having a plane orientation of (110); and rapidly annealing the silicon single-crystal substrate to form a surface stable structure 1×1 in a room temperature environment.

In the method of forming the surface stable structure 1×1 in a room temperature environment by rapid annealing as above, first, the rapid annealing is a method of rapidly annealing only the outermost surface of the substrate, which rapidly raises the temperature of only the outermost surface of the substrate and does not raise the temperature of the substrate other than the outermost surface thereof. Thus, this method allows the temperature of only the outermost surface of the substrate to reach the desired temperature in an extremely short time to form the surface stable structure 1×1. Due to the surface stable structure 1×1, the haze can be reduced differing from the structure having a step equivalent to two atoms like the surface stable structure 16×2. Second, since the rapid annealing is performed in a room temperature environment, temperature of the substrate other than the outermost surface is maintained at the room temperature, and after the rapid annealing is finished, the temperature of the outermost surface of the substrate can be returned to room temperature in an extremely short time. Thus, since the temperature of the outermost surface of the substrate can be instantly passed through the structure transition temperature (600 to 800°C) in both heating of the rapid annealing and cooling after the finish, the structure hardly changes to allow the substrate to have the stable surface structure.

### ADVANTAGEOUS EFFECTS OF INVENTION

The silicon single-crystal substrate of the present invention is the silicon (110) substrate having the surface stable structure 1×1 in a room temperature environment, and has reduced haze differing from the structure having a step equivalent to two atoms like the surface stable structure 16×2. Second, due to the room temperature environment, which is distanced from the structure transition temperature of the silicon (110) substrate (600 to 800°C), the structure hardly changes to allow the substrate to have the stable surface structure.

In addition, the method for manufacturing a silicon single-crystal substrate of the present invention is a method of forming the surface stable structure 1×1 in a room temperature environment by the rapid annealing, which can reduce the haze differing from the structure having a step equivalent to two atoms like the surface stable structure 16×2. In addition, since the temperature of the outermost surface of the substrate can be instantly passed through the structure transition temperature (600 to 800°C) in both heating of the rapid annealing and cooling after the finish, the structure hardly changes to allow the substrate to have the stable surface structure.

### BRIEF DESCRIPTION OF DRAWINGS

[FIG. 1] is a schematic view of a silicon single-crystal substrate in the first embodiment of the present invention;
[FIG. 2] is a schematic view showing a relationship between a surface temperature and a surface stable structure of a silicon (110) substrate;
[FIG. 3] is a flowchart of a method for manufacturing a silicon single-crystal substrate in the first embodiment of the present invention; and
[FIG. 4] is a schematic view of a conventional silicon single-crystal substrate.

### DESCRIPTION OF EMBODIMENTS

Hereinafter, the present invention will be described in detail, but the present invention is not limited thereto.

As noted above, there has been a demand for providing a silicon single-crystal substrate that has reduced haze of the silicon (110) substrate and thus has a stable surface structure, and a method for manufacturing the silicon single-crystal substrate.

The present inventors have intensively investigated the above problem, and consequently found that the phase of the surface stable structure does not change by instantly passing the temperature through a temperature range of 600 to 800°C, which is the structure transition temperature of the silicon (110) substrate. This finding has led to completion of the present invention.

Specifically, the silicon single-crystal substrate of the present invention is a silicon single-crystal substrate, having a plane orientation of (110), and a surface of the silicon single-crystal substrate in a room temperature environment has a surface stable structure 1×1.

In addition, the method for manufacturing a silicon single-crystal substrate of the present invention includes: providing a silicon single-crystal substrate having a plane orientation of (110); and rapidly annealing the silicon single-crystal substrate to form a surface stable structure 1×1 in a room temperature environment.

In specific, as a means for obtaining a stable surface with reduced haze, the surface stable structure 1×1 is formed at high temperature, and annealing is performed by rapid annealing (flash lamp annealing) to instantly pass the temperature through the structure transition temperature (600 to 800°C).

Here, the annealing activates dopants introduced by typically ion injection and recovers defects. However, conventional annealing using a common halogen lamp takes several seconds for heating, which causes a problem in which a steep profile formed by the ion injection is collapsed by diffusion of the dopants in this several seconds. Although the diffusion can be inhibited by lowering the heating temperature of the annealing, the low heating temperature has a demerit of insufficient activation and recovery of defects, which are the original purposes.

Meanwhile, the flash lamp annealing using a xenon flash lamp as the rapid annealing can solve this dilemma by providing heat only on the substrate surface in an extremely short time (millisecond order). The present invention uses this flash lamp annealing.

Using the flash lamp annealing as above can raise the surface temperature of the substrate from a room temperature environment (for example, 25°C) to about 1,200°C within several milliseconds, and after the heating is finished, the temperature can be returned from about 1,200°C to room temperature within a short time. Since the temperature of the outermost surface of the substrate can be instantly passed through the structure transition temperature (600 to 800°C), it is found that no time to change the structure is provided to retain the extremely stable surface structure. In this case, the surface stable structure 1×1 is formed at about 1,200°C, and the surface stable structure 1×1 can be retained even when the temperature is lowered to room temperature. In addition, with the surface stable structure 1×1, the haze can be reduced differing from the structure having a step equivalent to two atoms like the surface stable structure 16×2.

Hereinafter, embodiments of the present invention will be described regarding the drawings.

FIG. 1 is a schematic view of a silicon single-crystal substrate in the first embodiment of the present invention. A silicon single-crystal substrate 1 has a plane orientation of (110), and has a surface stable structure 2 of 1×1 in a room temperature environment on the surface. More specifically, the silicon single-crystal substrate 1 can be produced by heating only the substrate surface with rapid annealing (flash lamp annealing) to about 1,200°C within an extremely short time of several milliseconds to form the surface stable structure 1×1, and then returning the temperature of only the substrate surface to room temperature within an extremely short time.

Meanwhile, FIG. 4 is a schematic view of a conventional silicon single-crystal substrate. With a conventional common annealing method, the substrate is entirely heated to 1,200°C in an epi-furnace over a long time of several seconds or more, and then the temperature of the entire substrate is returned to room temperature over a similarly long time. In this case, only the surface stable structure 1×1 similar to that in FIG. 1 is formed in the 1,200°C-environment in the epi-furnace, but returning to the room temperature environment takes a long time, and the surface structure consequently causes change in phase in passing through the structure transition temperature (600 to 800°C) to form not only the surface stable structure 2 of 1×1 but also a surface stable structure 3 of 16×2 and a surface stable structure 4 of (17,15,1)2×1. As above, various structures are mixed on the surface to consequently increase the haze.

FIG. 2 is a schematic view showing a relationship between the surface temperature and the surface stable structure of the silicon (110) substrate. This summarizes understandings during further investigation in addition to the information in Non Patent Documents 2 and 3. Silicon (110) tends to form a surface stable structure 16×2 at a low temperature of 900 K (627°C) or less, tends to form a surface stable structure 1×1 at a high temperature of 1043 K (770°C) or more, and tends to form a surface stable structure (17,15,1)2×1 within a range of 900 K (627°C) to 1043 K (770°C). For example, the surface stable structure (17,15,1)2×1 is formed at 1003 K (730°C).

In addition, the surface stable structure 16×2 among these is a structure having a step equivalent to two atoms, the surface stable structure (17,15,1)2×1 is said to be a stepwise structure, and the surface stable structure 1×1 with few steps is more preferable. The surface stable structure 1×1 can reduce the haze the most.

Note that, since the surface stable structure 1×1 is formed at 1043 K (770°C) or more according to FIG. 2, the temperature may be freely selected within the range of 770°C or more without limitation to the example of about 1,200°C described by using FIG. 1 and FIG. 4.

FIG. 3 is a flowchart of a method for manufacturing a silicon single-crystal substrate in the first embodiment of the present invention.

First, a silicon single-crystal substrate having a plane orientation of (110) is provided in a step S1.

Next, the silicon single-crystal substrate is rapidly annealed to form the surface stable structure 1×1 in a room temperature environment in a step S2. This is a method of instantly heating only the outermost surface of silicon (110) by rapid annealing, forming the surface stable structure 1×1 at high temperature, and then rapidly cooling the silicon single-crystal substrate to inhibit the structure transition.

Here, as the method of this rapid annealing, flash lamp annealing using a flash lamp in which a noble gas such as xenon is sealed may be used. This flash lamp is for a method of radiating high energy of, for example, several tens of Joules per square centimeter or more as pulse light in 0.1 to 100 milliseconds.

In addition, the room temperature may be presumed to be 0 to 40°C, depending on the seasons, and may be, for example, 25°C using an air-conditioning facility.

In addition, the surface temperature of silicon (110) when the surface stable structure 1×1 is formed may be any as long as it is 850°C or more according to Non Patent Documents 2 and 3 and understandings through further investigation. The surface temperature may be set to, for example, 1,200°C or less, and may be specifically set to 1,200°C.

The condition range as above allows the heating time and the cooling time to be several milliseconds, and can instantly pass the temperature through the structure transition temperature (600 to 800°C). As a result, the silicon single-crystal substrate having the surface stable structure 1×1 in a room temperature environment can be manufactured.

### EXAMPLE

Hereinafter, the present invention will be specifically described with Example and Comparative Example, but these do not limit the present invention.

### [Example 1]

Provided were boron-doped silicon single-crystal substrates having a diameter of 300 mm, a plane orientation (110), and a resistance of 10 Ω·cm, and flash lamp annealing was continuously performed on 25 of the substrates in a room temperature environment.
- Energy of flash lamp: 30 J/cm²
- Pulse width of flash lamp: 5 milliseconds (1 pulse)
- Surface temperature of single-crystal silicon substrate: 1,200°C in average
- Room temperature: 25°C
- Time for passing through structure transition temperature (600 to 800°C): 5 milliseconds in average

Thereafter, the haze was measured with an optical defect inspector (SurfScan-SP3, manufactured by KLA-Tencor Corporation, hereinafter referred to as KLA/SP-3), and the haze values of the 1st to 25th substrates were stable at low values of between 0.7 to 0.8 ppm. The surface stable structure was determined with an atomic force microscope (AFM) to be 1×1.

### [Comparative Example 1]

Provided were boron-doped silicon single-crystal substrates having a diameter of 300 mm, a plane orientation (110), and a resistance of 10 Ω·cm, and hydrogen annealing was continuously performed on 25 of the substrates with an epi-furnace at 1,140°C.
- Surface temperature (and entire temperature) of single-crystal silicon substrate: 1,140°C
- Room temperature: 25°C
- Time for passing through structure transition temperature (600 to 800°C): 10 seconds in average

Thereafter, the haze was measured with KLA/SP-3. The haze values of the 1st to 25th substrates were 1 to 2.5 ppm, which were larger than those in Example 1, and tendency of large variation was observed. The surface stable structure was determined with an AFM to be 16×2.

As above, it was found that Example 1 exhibited low and stable haze values compared with those in Comparative Example 1.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A silicon single-crystal substrate, having a plane orientation of (110), wherein a surface of the silicon single-crystal substrate in a room temperature environment has a surface stable structure 1×1.

2. A method for manufacturing a silicon single-crystal substrate, the method comprising:
providing a silicon single-crystal substrate having a plane orientation of (110); and
rapidly annealing the silicon single-crystal substrate to form a surface stable structure 1×1 in a room temperature environment.
